# EUROPÄISCHE PATENTSCHRIFT

(11) **EP 2 359 156 B1**
(45) Veröffentlichungstag und Bekanntmachung des Hinweises auf die Patenterteilung: **06.03.2019**
(21) Anmeldenummer: 09752393.0
(22) Anmeldetag: 19.11.2009
(51) Int. Cl.: G01R 31/36

(54) **VORRICHTUNG FÜR SYNCHRONISIERTE ZELLENSPANNUNGSMESSUNG AN MEHREREN ELEKTRISCHEN SPEICHERZELLEN**
DEVICE FOR SYNCHRONIZED CELL VOLTAGE MEASUREMENTS IN SEVERAL ELECTRIC STORAGE CELLS
DISPOSITIF DESTINÉ À LA MESURE SYNCHRONISÉE DE TENSIONS SUR PLUSIEURS ÉLÉMENTS D'ACCUMULATEUR ÉLECTRIQUE

(30) Priorität: 20.11.2008 DE 102008043921
(43) Veröffentlichungstag der Anmeldung: 24.08.2011
(73) Patentinhaber: Robert Bosch GmbH, 70442 Stuttgart (DE)
(72) Erfinder: BUTZMANN, Stefan, 71717 Beilstein (DE)
(86) Internationale Anmeldenummer: PCT/EP2009/065484
(87) Internationale Veröffentlichungsnummer: WO 2010/057954

(56) Entgegenhaltungen:
- JP-A- 11 109 005
- US-A- 5 760 587
- US-A1- 2008 282 018
- US-B1- 6 313 637

## Beschreibung

Die Erfindung betrifft eine Vorrichtung zum Messen der elektrischen Zellspannungen an mehreren elektrischen Speicherzellen eines elektrischen Speichers, wobei jede Speicherzelle eine zugeordnete Messeinrichtung aufweist und die Messwerte der Messeinrichtungen aufgrund eines Lesebefehls einer Steuereinheit ausgelesen werden. Ferner betrifft die Erfindung ein entsprechendes Verfahren.

### Stand der Technik

Vorrichtungen der oben genannten Art sind bekannt. Für stationäre Anwendungen, wie beispielsweise Windkraftanlagen sowie in Fahrzeugen, wie beispielsweise in Hybrid- und Elektrofahrzeugen, werden neue elektrische Speicher benötigt, an die sehr hohe Anforderungen bezüglich Ihrer Zuverlässigkeit gestellt werden. Diese ergeben sich daraus, dass ein Ausfall derartiger Speicher zu einem Ausfall eines Gesamtsystems, wie beispielsweise eines gesamten Elektrofahrzeugs führen kann. Im Beispiel des Elektrofahrzeugs kann ein Ausfall einer Traktionsbatterie, also einem Speicher, welche den Antrieb des Elektrofahrzeugs speist, zu einem Ausfall des gesamten Elektrofahrzeugs führen. Weiter kann ein Ausfall der Speicher zu sicherheitsrelevanten Problemen führen. Im Beispiel einer Windkraftanlage werden beispielsweise Speicher eingesetzt, um bei starkem Wind die Windkraftanlage durch eine mittels der Speicher gespeiste Rotorblattverstellung vor unzulässigen Betriebszuständen zu schützen.

Elektrische Speicher dieser Art werden, um die geforderten Leistungs- und Energiedaten zu erzielen, aus einzelnen Speicherzellen hergestellt, die in Reihe zueinander geschaltet werden. Teilweise kann es vorgesehen sein, dass mehrere Speicherzellen zusätzlich parallel zueinander geschaltet werden. Die in Reihe geschalteten Speicherzellen müssen während eines Betriebs des elektrischen Speichers hinsichtlich Ihrer elektrischen Zellenspannungen überwacht werden. Hierzu werden Messeinrichtungen verwendet, die in Reihe zueinander und parallel zu den Speicherzellen betrieben werden. Typischerweise kommuniziert nur eine erste Messeinrichtung mit einer zentralen Steuereinheit, während alle anderen Messeinrichtungen über einen Datenbus mit der jeweils vorangegangenen Messeinrichtung verbunden sind. Sollen die elektrischen Zellenspannungen aller Speicherzellen gemessen werden, so sendet die zentrale Steuereinheit einen Lesebefehl an die erste Messeinrichtung, die diesen an die nachfolgende Messeinrichtung weitergibt. Dies hat zur Folge, dass der Lesebefehl an der für den Lesebefehl letzten Messeinrichtung mit einer Verzögerung ankommt. Diese Verzögerung ergibt sich aus der Einzellaufzeit des Lesebefehls von einer Messeinrichtung zur nächst folgenden Messeinrichtung multipliziert mit der Anzahl der Messeinrichtungen. Aufgrund dieser Vorgehensweise kommt es zu zeitlich versetzten Messungen der einzelnen Zellenspannungen.

Relevante Dokumente aus dem Stand der Technik sind US6313637B1, US5760587A, US2008/282018A1 sowie JP11109005A.

Aufgabe der Erfindung ist es ein gleichzeitiges Messen der elektrischen Zellenspannungen an allen Messeinrichtungen zu ermöglichen.

### Offenbarung der Erfindung

Erfindungsgemäß wird eine Vorrichtung zum Messen der elektrischen Zellenspannungen an mehreren elektrischen Speicherzellen eines elektrischen Speichers im unabhängigen Anspruch 1 und ein entsprechendes Verfahren im unabhängigen Anspruch 5 definiert.

Es ist vorgesehen, dass zum gleichzeitigen Auslesen der Messwerte eine von der Steuereinheit zu den Messeinrichtungen oder von einer der Messeinrichtungen zu allen anderen Messeinrichtungen führende Synchronisierungsleitung vorgesehen ist. Die Synchronisierungsleitung ermöglicht es, dass alle Messeinrichtungen gleichzeitig ein Synchronisationssignal zugeführt wird, welches bewirkt, dass alle Messeinrichtungen zur gleichen Zeit die Zellenspannungen messen. Die Synchronisierungsleitung kann dabei entweder von der Steuereinheit selbst oder eine der Messeinrichtungen, insbesondere der Messeinrichtung, die direkt mit der Steuereinheit verbunden ist, mit dem Synchronisationssignal beaufschlagt werden. Vorteil bei einer Synchronisierungsleitung, welche mit der Steuereinheit verbunden ist, ist eine gemeinsame Kontrolle von dem Senden des Lesebefehls und einem Senden des Synchronisationssignals durch die Steuereinheit. Ist die Synchronsisierungsleitung von einer der Messeinrichtungen zu allen anderen Messeinrichtungen vorgesehen, ergibt sich der Vorteil, dass die Steuereinheit in einfacher Weise von den Messeinrichtungen beabstandet angeordnet werden kann. Ferner ergibt sich eine Vereinfachung in dem Aufbau der Synchronisierungsleitung.

Nach einer Weiterbildung der Erfindung ist vorgesehen, dass die Synchronisierungsleitung mindestens eine potentialfreie Signalkopplungsvorrichtung aufweist. Die potentialfreie Signalkopplungsvorrichtung entkoppelt mindestens eine Messeinrichtung von allen anderen Messeinrichtungen und von der Steuereinheit. Dies führt zu einer Verbesserung der Messergebnisse, sowie zu einer erhöhten Sicherheit bei der Verwendung der Messeinrichtungen.

Nach einer Weiterbildung der Erfindung ist vorgesehen, dass die Signalkopplungsvorrichtung ein Optokoppler, ein magnetoresisitiver Koppler und/oder ein kapazitiver Koppler ist. Im Falle eines Optokopplers ist die Signalkopplungsvorrichtung mit mindestens einer Messvorrichtung über eine optische Verbindung und gleichzeitig über eine elektrische Verbindung mit einer anderen der Messeinrichtungen oder der Steuereinheit verbunden. Der magnetoresitive Koppler und der kapazitive Koppler sind auf elektrische Weise mit den Messeinrichtungen verbunden. Sie bilden zwei getrennte Stromkreise aus, wobei ein Stromkreis mit einer Messeinrichtungen und der andere Stromkreis entweder mit einer der anderen Messeinrichtungen oder mit der Steuereinheit verbunden ist. Daraus ergibt sich, dass die Signalkopplungsvorrichtung das Synchronisationssignal von Steuereinheit oder Messeinrichtung zu den Messeinrichtungen umsetzt.

Nach einer Weiterbildung der Erfindung ist vorgesehen, dass jeder Messeinrichtung eine Signalkopplungsvorrichtung zugeordnet ist. In dieser besonders vorteilhaften Weiterbildung werden die einzelnen Zellenspannungen jeweils von einer Messeinrichtung erfasst. Dies führt dazu, dass sämtliche Zellenspannungen gleichzeitig besonders genau und schnell erfasst werden können.

Nach einer Weiterbildung der Erfindung ist mindestens eine eine Signallaufzeit des Lesebefehls berücksichtigende Latenzwartezeitvorrichtung vorgesehen. Die Latenzwartezeitvorrichtung erzeugt eine Latenzwartezeit für das Senden des Synchronisationssignals. Die Latenzwartezeitvorrichtung nimmt vorzugsweise das Senden des Lesebefehls als Startzeitpunkt für die Latenzwartezeit und ermöglicht ein Senden des Synchronisationssignals erst nach Ablauf der Latenzwartezeit.

Die Erfindung betrifft weiter ein Verfahren zum Messen der elektrischen Zellenspannungen an mehreren elektrischen Speicherzellen eines elektrischen Speichers, insbesondere mittels einer der vorstehend beschriebenen Vorrichtungen, wobei jede Speicherzelle eine zugeordnete Messeinrichtung ausweist und die Messwerte der Messeinrichtungen aufgrund eines Lesebefehls einer Steuereinheit ausgelesen werden. Es ist vorgesehen, dass zum gleichzeitigen Auslesen der Messwerte ein Synchonisiationssignal von der Steuereinheit zu den Messeinrichtungen oder von einer der Messeinrichtungen zu allen anderen Messeinrichtungen gesendet wird. Das Synchronisationssignal wird vorzugsweise über eine Synchronisierungsleitung gesendet. Es kann beispielsweise als positive oder negative elektrische Flanke ausgebildet sein und führt in den Messeinrichtungen zum Auslösen des Auslesens der Messwerte. Somit erhalten die Messeinrichtungen zunächst den Lesebefehl, welcher erst in Verbindung mit dem Synchronisationssignal ausgeführt wird. Dies führt dazu, dass trotz der Signallaufzeit des Lesebefehls alle elektrischen Zellenspannungen gleichzeitig ausgelesen werden können.

Nach einer Weiterbildung der Erfindung ist vorgesehen, dass das Synchronisiationssignal nach einem Senden des Lesebefehls und einer anschließenden Latenzwartezeit gesendet wird. In diesem Fall wird die Latenzwartezeit abgewartet, bis das Synchronisationssignal das eigentliche Auslesen der elektrischen Zellenspannungen bewirkt. Somit kann die Signallaufzeit des Lesebefehls berücksichtigt werden.

Nach einer Weiterbildung der Erfindung ist vorgesehen, dass als Latenzwartezeit mindestens eine maximale Laufzeit des Lesebefehls von einem Senden bis zu seinem Empfang an allen zugeordneten Messeinrichtungen gewählt wird. Die maximale Laufzeit des Lesebefehls ergibt sich aus den maximalen Einzellaufzeiten des Lesebefehls zwischen zwei Messeinrichtungen multipliziert mit der Anzahl aller vorhandenen Messeinrichtungen.

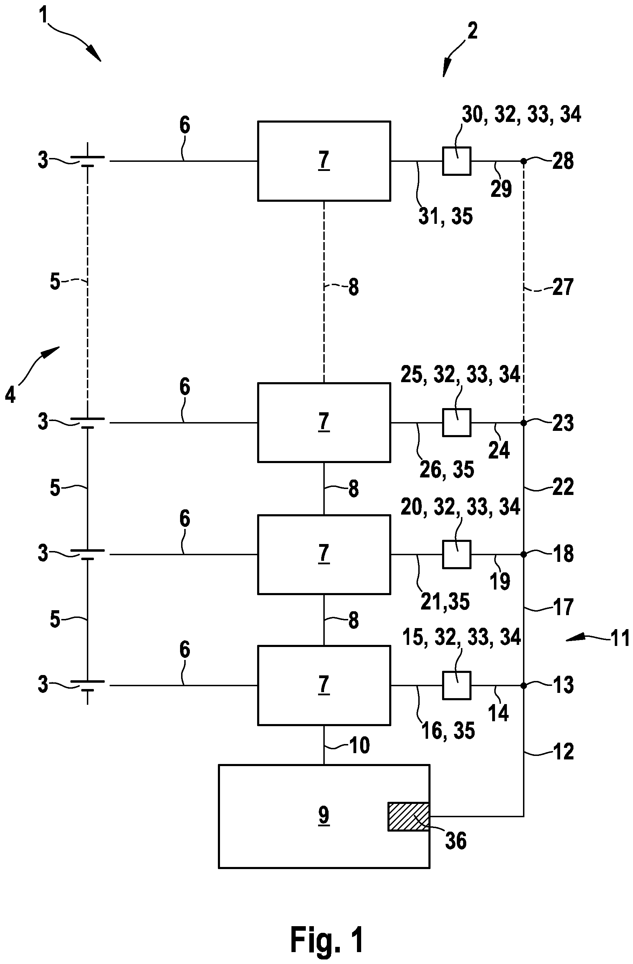

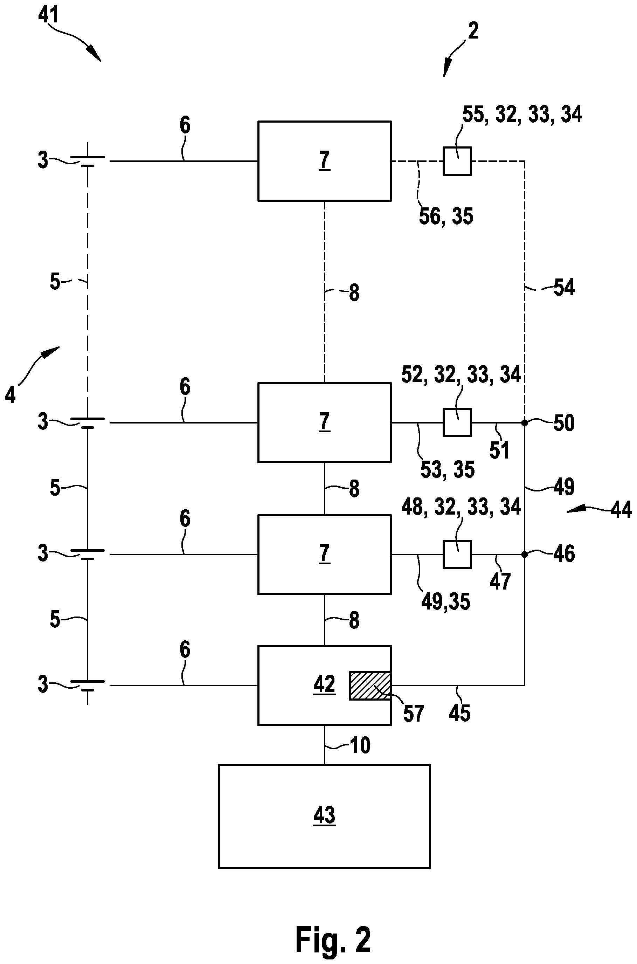

Im Folgenden wird die Erfindung anhand von Ausführungsbeispielen verdeutlicht. Die Abbildungen 1 und 2 veranschaulichen zwei Ausführungsbeispiele der erfindungsgemäßen Vorrichtung und zwar zeigen:
- Figur 1: eine erste Ausführungsform der erfindungsgemäßen Vorrichtung und
- Figur 2: eine zweite Ausführungsform der erfindungsgemäßen Vorrichtung.

Die Figur 1 zeigt eine erste Ausführungsform 1 der erfindungsgemäßen Vorrichtung 2 zum Messen elektrischer Zellenspannungen an mehreren elektrischen Speicherzellen 3 eines elektrischen Speichers 4. Die Speicherzellen 3 sind mittels Leitungen 5 in Reihe zueinander geschaltet. Über Messleitungen 6 sind die einzelnen Speicherzellen 3 jeweils mit einer ihnen zugeordneten Messeinrichtung 7 verbunden. Die Messeinrichtungen 7 sind ihrerseits mittels jeweils einer BUS-Leitungen 8 in Reihe geschaltet. Die Vorrichtung 2 weist weiter eine Steuereinheit 9 auf, welche mittels einer BUS-Leitung 10 mit einer der Messeinrichtungen 7 verbunden ist. Von der Steuereinheit 9 geht zusätzlich eine Synchronisierungsleitung 11 aus, welche zu allen Messeinrichtungen 7 führt. Die Synchronisierungsleitung 11 weist eine erste Leitung 12 auf, welche von der Steuereinheit 9 zu einem ersten Knotenpunkt 13 führt. Ausgehend vom Knotenpunkt 13 verläuft eine Leitung 14 zu einer potientialfreien Signalkopplungsvorrichtung 15, welche über eine Leitung 16 mit einer der Messeinrichtungen 7 verbunden ist. Ausgehend vom Knotenpunkt 13 verläuft eine weitere Leitung 17 zu einem Knotenpunkt 18. Der Knotenpunkt 18 ist über eine Leitung 19 mit einer weiteren Signalkopplungsvorrichtung 20 verbunden. Die Signalkopplungsvorrichtung 20 ist ihrerseits über eine Leitung 21 mit einer der Messeinrichtungen 7 verbunden. Ausgehend von dem Knotenpunkt 18 verläuft eine Leitung 22 zu einem Knotenpunkt 23. Der Knotenpunkt 23 ist über eine Leitung 24 mit einer weiteren Signalkopplungsvorrichtung 25 verbunden. Die Signalkopplungsvorrichtung 25 ist über eine Leitung 26 mit einer der Messeinrichtungen 7 verbunden. Ausgehend von Knotenpunkt 23 verläuft eine Leitung 27 zu einem Knotenpunkt 28, der über eine Leitung 29 an eine zusätzliche Signalkopplungsvorrichtung 30 angeschlossen ist. Die Signalkopplungsvorrichtung 30 ist über eine Leitung 31 mit einer weiteren Messeinrichtung 7 verbunden. Die Darstellung in Figur 1 ist eine auschnittsweise Darstellung der erfindungsgemäßen Vorrichtung 2 und des elektrischen Speichers 4. Sie kann in logischer Weise in den gestrichelten Bereichen, also in der gestrichelt dargestellten Leitung 5, der entsprechenden BUS-Leitung 8 und der entsprechenden Leitungen 27 fortgeführt werden. Die Signalkopplungsvorrichtungen 15, 20, 25 und 30 können unterschiedlich ausgebildet sein. Es sind Ausbildungen als Optokoppler 32, magnetoresitiver Koppler 33 und/oder kapazitive Koppler 34 denkbar. Im Falle einer Ausbildung als Optokoppler 32 sind die Leitungen 16, 21, 26 und 31 als optische Leitungen 35 ausgebildet. Innerhalb der Steuereinheit 9 ist eine Latenzwartezeitvorrichtung 36 vorgesehen, welche mit der Synchronisierungsleitung 11 zusammenwirkt.

Zum Messen der elektrischen Zellenspannung der Speicherzellen 3 sendet die Steuereinheit 9 einen Lesebefehl über die BUS-Leitung 10 an die mit der BUS-Leitung 10 verbundene Messeinrichtung 7. Die Messeinrichtung 7 gibt ihrerseits über die BUS-Leitung 8 den Lesebefehl weiter. Auf diese Weise verfahren sämtliche Messeinrichtungen 7 sofern sie eine benachbarte Messeinrichtung 7 aufweisen, welcher der Lesebefehl zugeführt werden soll. Innerhalb jeder Messeinrichtung 7 wird der Lesebefehl registriert, jedoch kein Auslesen der Messwerte vorgenommen. Innerhalb der Steuereinheit 9 wird von der Latenzwartezeitvorrichtung 36 der Zeitpunkt des Aussendens des Lesebefehls an die BUS-Leitung 10 festgehalten und eine Latenzwartezeit abgewartet. Im Anschluss an die Latenzwartezeit gibt die Latenzwartezeitvorrichtung 36 ein Synchronisationssignal in die Synchronisierungsleitung 11 aus. Das Synchronisationssignal verläuft dann zunächst über die Leitung 12 zu den Signalkopplungsvorrichtungen 15, 20, 25 und 30. Diese setzen das Synchronisationssignal in einer Weise um, die es erlaubt, dass die Messeinrichtungen 7 von der Steuereinheit 9 nicht elektrotechnisch direkt miteinander verbunden sind. Die Signalkopplungsvorrichtungen 15, 20, 25 und 30 geben anschließend das Synchronisationssignal über die Leitungen 16, 21, 26 und 31 an die jeweiligen Messeinrichtungen 7 weiter. Das Synchronisationssignal erfolgt in Form einer Signalflanke und wirkt in den Messeinrichtungen 7 als Auslöser für das Auslesen der Messwerte. Diese werden über die Messleitungen 6 von den Speicherzellen 3 erfasst. Abschließend können sämtliche erfassten Messwerte über die BUS-Leitungen 8 und 10 an die Steuereinheit 9 zurückgeführt werden. Um die Latenzwartezeit korrekt einzustellen, ist es in der Latenzwartezeitvorrichtung 36 vorgesehen, die Latenzwartezeit manuell auswählen zu können. Insbesondere ist es vorgesehen, eine maximale Laufzeit des Lesebefehls von der Steuereinheit 9 bis zur letzten Messeinrichtung 7, das heißt in Laufrichtung des Lesebefehls letzte Messeinrichtung 7, zu verwenden. In diesem Fall ist gewährleistet, dass bei Aussenden des Synchronisationssignals sämtliche Messeinrichtungen 7 den Lesebefehl bereits erhalten haben. Dieses Vorgehen sichert, dass sämtliche Zellenspannungen zur gleichen Zeit erfasst werden können.

Die Figur 2 zeigt eine zweite Ausführungsform 41 der erfindungsgemäßen Vorrichtung 2 zum Messen elektrischer Zellenspannungen an mehreren elektrischen Speicherzellen 3 des elektrischen Speichers 4. Die Speicherzellen 3 sind mittels Leitungen 5 in Reihe zueinander geschaltet. Über die Messleitungen 6 sind die einzelnen Speicherzellen 3 jeweils mit der ihnen zugeordneten Messeinrichtung 7 und 42 verbunden. Die Messeinrichtungen 7 und 42 sind ihrerseits mittels jeweils einer BUS-Leitungen 8 in Reihe geschaltet. Die Vorrichtung 2 weist weiter eine Steuereinheit 43 auf, welche ihrerseits mittels einer BUS-Leitung 10 mit der Messeinrichtung 42 verbunden ist. Von der Messeinrichtung 42 geht eine Synchronisierungsleitung 44 aus, welche zu allen Messeinrichtungen 7 führt. Die Synchronisierungsleitung 44 weist eine erste Leitung 45 auf, welche von der Steuereinheit 43 zu einem ersten Knotenpunkt 46 führt. Ausgehend vom Knotenpunkt 46 verläuft eine Leitung 47 zu einer potientialfreien Signalkopplungsvorrichtung 48, welche über eine Leitung 49 mit einer der Messeinrichtungen 7 verbunden ist. Ausgehend vom Knotenpunkt 46 verläuft eine weitere Leitung 49 zu einem Knotenpunkt 50. Der Knotenpunkt 50 ist über eine Leitung 51 mit einer weiteren Signalkopplungsvorrichtung 52 verbunden. Die Signalkopplungsvorrichtung 52 ist ihrerseits über eine Leitung 53 mit einer der Messeinrichtungen 7 verbunden. Ausgehend vom Knotenpunkt 50 verläuft eine Leitung 54 zu einer weiteren Signalkopplungsvorrichtung 55. Die Signalkopplungsvorrichtung 55 ist über eine Leitung 56 mit einer der Messeinrichtungen 7 verbunden. Die Darstellung in Figur 2 ist eine auschnittsweise Darstellung der erfindungsgemäßen Vorrichtung 2 und des elektrischen Speichers 4. Sie kann in logischer Weise in den gestrichelten Bereichen, also in der gestrichelt dargestellten Leitung 5, der entsprechenden BUS-Leitung 8 und der zugehörigen Leitungen 54 fortgeführt werden. Die Signalkopplungsvorrichtungen 48, 52 und 56 können unterschiedlich ausgebildet sein. Es sind Ausbildungen als Optokoppler 32, magnetoresitiver Koppler 33 und/oder kapazitive Koppler 34 denkbar. Im Falle einer Ausbildung als Optokoppler 32 sind die Leitungen 49, 53 und 56 als optische Leitungen 35 ausgebildet. Innerhalb der Messeinrichtung 42 ist eine Latenzwartezeitvorrichtung 57 vorgesehen, welche mit der Synchronisierungsleitung 44 zusammenwirkt.

Zum Messen der elektrischen Zellenspannung der Speicherzellen 3 sendet die Steuereinheit 43 einen Lesebefehl über die BUS-Leitung 10 an die mit der BUS-Leitung 10 verbundene Messeinrichtung 42. Die Messeinrichtung 42 gibt ihrerseits über die BUS-Leitung 8 den Lesebefehl weiter. Auf diese Weise verfahren auch sämtliche Messeinrichtungen 7 sofern sie eine benachbarte Messeinrichtung 7 aufweisen, welcher der Lesebefehl zugeführt werden soll. Innerhalb der Messeinrichtungen 7 und 42 wird der Lesebefehl registriert, jedoch kein Auslesen der Messwerte vorgenommen. Innerhalb der Messeinrichtung 42 wird von der Latenzwartezeitvorrichtung 57 das Aussenden des Lesebefehls an die BUS-Leitung 10 registriert und eine Latenzwartezeit abgewartet. Im Anschluss an die Latenzwartezeit gibt die Latenzwartezeitvorrichtung 57 ein Synchronisationssignal in die Synchronisierungsleitung 44 aus. Das Synchronisationssignal verläuft dann zunächst über die Leitung 45 zu den Signalkopplungsvorrichtungen 48, 52 und 55. Diese setzen das Synchronisationssignal in einer Weise um, die es erlaubt, dass die Messeinrichtungen 7 von der Messeinrichtung 42 nicht elektrotechnisch direkt verbunden sind. Die Signalkopplungsvorrichtungen 49, 53 und 55 geben anschließend das Synchronisationssignal über die Leitungen 49, 53 und 56 an die jeweiligen Messeinrichtungen 7 weiter. Das Synchronisationssignal erfolgt in Form einer Signalflanke und wirkt in den Messeinrichtungen 7 und 42 als Auslöser für das Auslesen der Messwerte. Diese werden über die Messleitungen 6 von den Speicherzellen 3 erfasst. Abschließend können sämtliche erfassten Messwerte über die BUS-Leitungen 8 und 10 an die Steuereinheit 43 zurückgeführt werden. Um die Latenzwartezeit korrekt einzustellen, ist es in der Latenzwartezeitvorrichtung 57 vorgesehen, die Latenzwartezeit wählen zu können. Insbesondere ist es vorgesehen, eine maximale Laufzeit des Lesebefehls von der Steuereinheit 43 bis zur letzten Messeinrichtung 7, das heißt in Laufrichtung des Lesebefehls letzte Messeinrichtung 7, zu verwenden. In diesem Fall ist gewährleistet, dass bei Aussenden des Synchronisationssignals sämtliche Messeinrichtungen 7 und 42 den Lesebefehl bereits erhalten haben. Dieses Vorgehen sichert, dass sämtliche Zellenspannungen zur gleichen Zeit erfasst werden können.

## Patentansprüche

1. Vorrichtung (2) zum Messen der elektrischen Zellenspannungen an mehreren elektrischen Speicherzellen (3) eines elektrischen Speichers (4), wobei die Vorrichtung eine Steuereinheit (9, 43) und die elektrischen Speicherzellen (3) umfasst und jede elektrische Speicherzelle (3) eine zugeordnete Messeinrichtung (7, 42) aufweist, die ausgebildet ist, aufgrund eines Lesebefehls der Steuereinheit (9, 43) Messwerte auszulesen, wobei die Vorrichtung weiterhin eine zum gleichzeitigen Auslesen der Messwerte von der Steuereinheit (9,43) zu den Messeinrichtungen (7) oder von einer der Messeinrichtungen (42) zu allen anderen Messeinrichtungen (7) führende Synchronisierungsleitung (11,44) umfasst, **gekennzeichnet durch** mindestens eine, eine maximale Signallaufzeit des Lesebefehls von einem Senden bis zu seinem Empfang an allen zugeordneten Messeinrichtungen (7, 42) berücksichtigende Latenzwartezeitvorrichtung (36,57).

2. Vorrichtung (2) nach Anspruch 1, **dadurch gekennzeichnet, dass** die Synchronisierungsleitung (11,44) mindestens eine potentialfreie Signalkopplungsvorrichtung (15,20,25,30,48,52,55) aufweist.

3. Vorrichtung (2) nach einem der vorhergehenden Ansprüche, **dadurch gekennzeichnet, dass** die Signalkopplungsvorrichtung (15,20,25,30,48,52,55) ein Optokoppler (32), ein magnetoresistiver Koppler (33) und/oder ein kapazitiver Koppler (34) ist.

4. Vorrichtung (2) nach einem der vorhergehenden Ansprüche, **dadurch gekennzeichnet, dass** jeder Messeinrichtung (7) eine Signalkopplungsvorrichtung (15,20,25,30,48,52,55) zugeordnet ist.

5. Verfahren zum Messen der elektrischen Zellenspannungen an mehreren elektrischen Speicherzellen (3) eines elektrischen Speichers (4), insbesondere mittels einer Vorrichtung (2) nach einem oder mehreren der vorhergehenden Ansprüche, wobei jede Speicherzelle (3) eine zugeordnete Messeinrichtung (7,42) aufweist und die Messwerte der Messeinrichtungen (7,42) aufgrund eines Lesebefehls einer Steuereinheit (9,43) ausgelesen werden und zum gleichzeitigen Auslesen der Messwerte ein Synchronisationssignal von der Steuereinheit (9,43) zu den Messeinrichtungen (7) oder von einer der Messeinrichtungen (42) zu allen anderen Messeinrichtungen (7) gesendet wird, **dadurch gekennzeichnet, dass** das Synchronisationssignal nach einem Senden des Lesebefehls und nach einer anschließenden Latenzwartezeit, die mindestens eine maximale Laufzeit des Lesebefehls bis zu seinem Empfang an allen zugeordneten Messeinrichtungen (7, 42) umfasst, gesendet wird.

## Claims

1. Apparatus (2) for measuring the cell voltages on multiple electrical storage cells (3) of an electrical store (4), wherein the apparatus comprises a control unit (9, 43) and the electrical storage cells (3), and each electrical storage cell (3) has an associated measuring device (7, 42) designed to read measured values on the basis of a read command of the control unit (9, 43), wherein the apparatus moreover comprises a synchronization line (11, 44) leading from the control unit (9, 43) to the measuring devices (7) or from one of the measuring devices (42) to all other measuring devices (7) for the purpose of simultaneously reading the measured values, **characterized by** at least one latency waiting time apparatus (36, 57) taking into consideration a maximum signal propagation time for the read command from sending to reception thereof at all associated measuring devices (7, 42).

2. Apparatus (2) according to Claim 1, **characterized in that** the synchronization line (11, 44) has at least one zero-potential signal coupling apparatus (15, 20, 25, 30, 48, 52, 55).

3. Apparatus (2) according to either of the preceding claims, **characterized in that** the signal coupling apparatus (15, 20, 25, 30, 48, 52, 55) is an optocoupler (32), a magnetoresistive coupler (33) and/or a capacitive coupler (34).

4. Apparatus (2) according to one of the preceding claims, **characterized in that** each measuring device (7) has an associated signal coupling apparatus (15, 20, 25, 30, 48, 52, 55).

5. Method for measuring the cell voltages on multiple electrical storage cells (3) of an electrical store (4), in particular by means of an apparatus (2) according to one or more of the preceding claims, wherein each storage cell (3) has an associated measuring device (7, 42) and the measured values of the measuring devices (7, 42) are read on the basis of a read command of a control unit (9, 43) and a synchronization signal is sent from the control unit (9, 43) to the measuring devices (7) or from one of the measuring devices (42) to all other measuring devices (7) for the purpose of simultaneously reading the measured values, **characterized in that** the synchronization signal is sent after the read command is sent and after a subsequent latency waiting time that comprises at least one maximum propagation time for the read command before reception thereof at all associated measuring devices (7, 42).

## Revendications

1. Arrangement (2) pour mesurer les tensions de cellule électriques sur plusieurs cellules d'accumulation électriques (3) d'un accumulateur électrique (4), l'arrangement comprenant une unité de commande (9, 43) et les cellules d'accumulation électriques (3) et chaque cellule d'accumulation électrique (3) possédant un dispositif de mesure (7, 42) associé qui est configuré pour relever des valeurs mesurées par suite d'une instruction de lecture de l'unité de commande (9, 43), l'arrangement comprenant en outre une ligne de synchronisation (11, 44) servant au relevé simultané des valeurs mesurées qui mène de l'unité de commande (9, 43) aux dispositifs de mesure (7) ou de l'un des dispositifs de mesure (42) à tous les autres dispositifs de mesure (7), **caractérisé par** au moins un arrangement à temps d'attente de latence (36, 57) qui tient compte d'un temps de propagation de signal maximal de l'instruction de lecture d'une émission jusqu'à sa réception au niveau de tous les dispositifs de mesure (7, 42) associés.

2. Arrangement (2) selon la revendication 1, **caractérisé en ce que** la ligne de synchronisation (11, 44) possède au moins un arrangement de couplage de signal (15, 20, 25, 30, 48, 52, 55) exempt de potentiel.

3. Arrangement (2) selon l'une des revendications précédentes, **caractérisé en ce que** l'arrangement de couplage de signal (15, 20, 25, 30, 48, 52, 55) est un optocoupleur (32), un coupleur magnétorésistif (33) et/ou un coupleur capacitif (34).

4. Arrangement (2) selon l'une des revendications précédentes, **caractérisé en ce qu'**un arrangement de couplage de signal (15, 20, 25, 30, 48, 52, 55) est associé à chaque dispositif de mesure (7).

5. Procédé pour mesurer les tensions de cellule électriques sur plusieurs cellules d'accumulation électriques (3) d'un accumulateur électrique (4), notamment au moyen d'un arrangement (2) selon l'une ou plusieurs des revendications précédentes, chaque cellule d'accumulation (3) possédant un dispositif de mesure (7, 42) associé et les valeurs mesurées des dispositifs de mesure (7, 42) étant relevées par suite d'une instruction de lecture d'une unité de commande (9, 43) et un signal de synchronisation étant envoyé de l'unité de commande (9, 43) aux dispositifs de mesure (7) ou de l'un des dispositifs de mesure (42) à tous les autres dispositifs de mesure (7) en vue du relevé simultané des valeurs mesurées, **caractérisé en ce que** le signal de synchronisation est envoyé après un envoi de l'instruction de lecture et après un temps d'attente de latence qui suit, lequel comprend au moins un temps de propagation de signal maximal de l'instruction de lecture jusqu'à sa réception au niveau de tous les dispositifs de mesure (7, 42) associés.
